# EUROPEAN PATENT APPLICATION

(11) **EP 3 561 553 A1**
(43) Date of publication of application: **30.10.2019**
(21) Application number: 18169272.4
(22) Date of filing: 25.04.2018
(51) Int. Cl.: G02B 3/00, G02B 27/09, H01S 5/00, H01S 5/02, H01S 5/022, H01S 5/026, H01S 5/183, H01S 5/42

(54) **LASER ARRANGEMENT WITH REDUCED SCATTERING LOSS**

(71) Applicant: Koninklijke Philips N.V., 5656 AE Eindhoven (NL)
(72) Inventor: GRONENBORN, Stephan, 5656 AE Eindhoven (NL)
(74) Representative: Witte, Weller & Partner Patentanwälte mbB

(57) **Abstract**

The invention describes a laser arrangement (100) comprising at least one laser (130) and at least one optical structure for providing a defined illumination pattern in a defined field of view, wherein the optical structure comprises a diffusor (140), wherein at least one surface of the diffusor (140) is characterized along a first axis (141) by a periodic continuously differentiable function with a first period, wherein the at least one laser (130) is arranged to emit laser light (10) to adjacent half periods with opposing radius of curvature of the at least one surface along the first axis (141) during operation of the laser arrangement (100).

The invention further describes a lighting device comprising such a laser arrangement (100) and a time of flight camera (200) comprising such a laser arrangement (100) or lighting device. The invention finally describes a method of manufacturing the laser arrangement (100).

## Description

### FIELD OF THE INVENTION

The invention relates to a laser arrangement comprising a laser array and especially a Vertical Cavity Surface Emitting Laser (VCSEL) array and a diffusor with reduced scattering loss, a lighting device comprising such a laser or VCSEL array, a time-of-flight camera comprising such a laser arrangement or lighting device and a method of manufacturing the laser arrangement.

### BACKGROUND OF THE INVENTION

Laser arrangements comprising a laser and especially a VCSEL array can be used for infrared illumination devices. Using short pulses VCSEL arrays are, for example, applied in time-of-flight applications. Such applications comprise e.g. short-range gesture recognition for portable devices and 3D space recognition. VCSEL arrays of about 1mm² area with output power in the 1-10W range are discussed for such applications. A specific field of illumination or view is defined by the application (e.g. a time-of-flight camera observing e.g. 70°x50°). Specific diffusor structures are used in order to tailor the emission pattern towards the application requirement. Most VCSEL-based illumination modules use refractive diffusors.

US 2004/130790 A1 discloses in this respect microlens arrays which are defined with microlens elements that differ from each other in accordance with a probability distribution for shaping an optical beam having a prescribed intensity profile within a desired far-field scatter pattern. The differences include random variations in a sag profile corresponding to a surface shape of the microlenses, a boundary profile corresponding to a boundary of the microlenses, and a spatial distribution corresponding to the relative position of the microlenses within the array.

### SUMMARY OF THE INVENTION

It is an object of the present invention to provide a laser arrangement with improved efficiency.

The invention is described in the independent claims. Preferred embodiments are described in the dependent claims or are described in the subsequent portions of the description.

According to a first aspect a laser arrangement comprising at least one laser, preferably a laser array comprising at least two lasers, and at least one optical structure for providing a defined illumination pattern in a defined field of view is provided. The at least one laser may be a VCSEL or the laser array may be a VCSEL array. The VCSEL array may comprise at least two VCSELs arranged on a common substrate. The common substrate may, for example, be a semiconductor substrate, especially a semiconductor (e.g. GaAs) growth substrate. At least one surface of the diffusor is characterized along a first axis by a periodic continuously differentiable function with a first period. Both surfaces of a diffusor may be characterized along the first axis by the periodic continuously differentiable function with the first period if the diffusor is arranged as a separate device such that both surfaces interact with laser light emitted by the lasers. The laser or the laser array is arranged to emit the laser light to adjacent half periods with opposing radius of curvature of the surface along the first axis during operation of the laser arrangement.

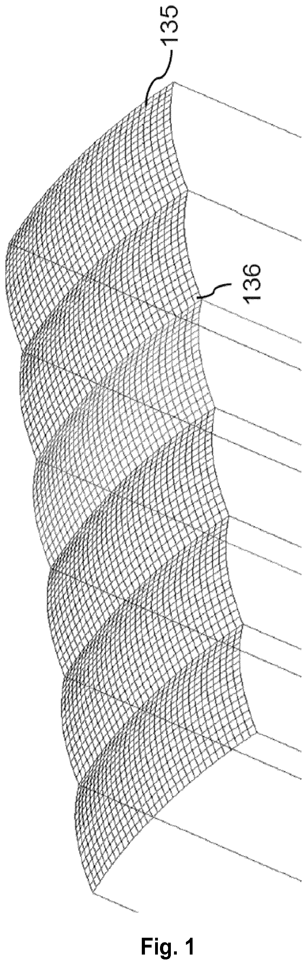

State-of-the-art diffusors as described, for example, in US 2004/130790 A1 cited above, use random arrangements of microlenses (random in diameter, decenter and position) to achieve the desired beam pattern (e.g. a rectangle of 100° x 80°) from a coherent, collimated beam. The beam has to illuminate a minimum area of the diffusor to illuminate enough microlenses to have enough randomization. A too small beam will result in inhomogeneities as only lenses with some shapes are illuminated while other shapes are not illuminated. The discontinuity between two lenses can never be produced perfectly sharp and will always lead to scattering and diffraction losses outside the intended field of view. An example of a prior art diffusor is discussed below with respect to Fig. 1. The scattering and diffraction losses reduce efficiency of laser arrangement comprising such a diffusor.

The proposed surface profile which is described by a smooth mathematical function avoids discontinuities at least along the first axis and may therefore improve efficiency of a laser arrangement because of reduction of scattering and diffraction losses outside the intended field of view.

The periodic continuously differentiable (smooth) function is characterized by adjacent local extrema (Minima and Maxima). The absolute values of the opposing radius of curvature in the local extrema may be the same for adjacent half periods along the first axis. The diffusor may, for example, comprise a regular arrangement of microlenses refracting the light to the desired profile where the radius of curvature is changed between adjacent microlenses to achieve an optical surface without discontinuities. The lenses may, for example, be biconical lenses (so independent Radius-of-curvature (ROC) and conical constant in the x and y direction), where the ROC in x direction is, for example, -0.15mm instead of 0.15mm for every second lens. The center height of each second lens is adapted, such that the height at the rim of each lens is the same as the neighboring lenses.

The at least one surface of the diffusor may be further characterized along a second axis different than the first axis by a periodic continuously differentiable function with a second period. The at least one surface of the diffusor is characterized in this embodiment by a two-dimensional continuously differentiable function in order to reduce diffraction and scattering losses. The laser or laser array (e.g. Vertical Cavity Surface Emitting Laser array) is arranged to emit the laser light to adjacent half periods with opposing radius of curvature along the first axis and the second axis during operation of the laser arrangement. The first and the second axis may, for example, be perpendicular to each other. A second surface of the diffusor may be characterized in the same way as described above. The surface or surfaces characterized by the two-dimensional continuously differentiable function may enable a flexible design of the illumination pattern in the field of view. The absolute values of the radius of curvature in the local extrema may, for example, be different along the first axis in comparison to the second axis. The first period may alternatively or in addition be different than the second period to enable, for example, rectangular illumination patterns in the field of view.

The laser array may comprise lasers, especially VCSELs, wherein each laser is arranged to emit the laser light to at least two adjacent half periods with opposing radius of curvature. The lasers are preferably arranged to emit laser light to a multitude (three, four, five or more) of adjacent half periods with opposing radius of curvature of the surface along at least the first axis during operation of the laser arrangement. The laser light needs not to illuminate full half periods of the multitude of half periods (e.g. 5.3 half periods). The lasers may be further arranged to emit laser light to two, three, four, five or more of adjacent half periods with opposing radius of curvature of the surface along the first and the second axis.

The first period may be characterized by a size of at least 3 µm, preferably at least 4 µm and most preferably at least 5 µm. The second period may optionally be characterized in the same way. The first period and optionally the second period of the smooth mathematical function define a feature size of the regular structures on the respective surface of the diffusor. The regular structures should be characterized by a diameter of more than 2 µm to avoid that diffraction effects, which may increase optical losses, decrease efficiency of the laser arrangement.

The lasers may be bottom emitting VCSELs which are arranged to emit the laser light through the substrate. The diffusor is in this embodiment provided on a surface of the (semiconductor) substrate opposing the side of the substrate on which the VCSELs are provided (deposited). The diffusor may be provided on a glass wafer which is bonded to the substrate. The diffusor may, for example, be etched in the glass wafer prior or after bonding to the wafer comprising the (semiconductor) substrates of the VCSEL array. The glass wafer may, for example, be glued to the substrates.

The diffusor may according to an alternative embodiment be integrated in a semiconductor structure, especially the substrate, of the VCSEL array. The high refractive index of the semiconductor substrate (gallium arsenide n ∼ 3.5) enables a relatively flat profile of the optical structure. A planarization layer may be provided after integrating the diffusor in the semiconductor substrate.

The lasers may alternatively be top emitting VCSELs which are arranged to emit the laser light in a direction away from the substrate. The diffusor comprises a material provided on top of the side of the substrate on which the VCSELs are provided. The material is transparent in the wavelength range of the laser light (e.g. in the wavelength range between 750 nm - 1200 nm). The transparent material may be UV- or blue light curable optical polymer as described below. The transparent material may be provided on top of the mesas of the VCSELs. Alternatively, a planarization layer may be provided in order to provide an essentially plain surface at the level of the light emitting areas of the single VCSEL. The transparent material of the optical structure may be deposited on top of the planarization layer.

At least a part of the lasers may be arranged to be individually controlled to emit the laser light. Each laser or two, three, four or more groups of lasers of the laser array may be arranged to be individually switched on or off in order to illuminate one or more sectors of the illumination pattern in a defined sequence. The laser array may comprise respective electrodes in order to enable individual control of the lasers or groups of lasers. Individual control of the lasers or groups of lasers (sub-arrays) may allow electronic adjustment of the illumination pattern (e.g. more light in a sector comprising an otherwise dark corner) or defined illumination sequences. The diffusor may in this embodiment comprise different sub-structures associated, for example, with switchable sub-arrays. The sub-structures may be characterized by different radius of curvature and/or different first or second period and/or different aspherical shapes.

According to a second aspect a light emitting device is provided. The light emitting device comprises at least one laser arrangement as described above and an electrical driver for electrically driving the lasers of the laser array. The light emitting device may further comprise a controller for providing control signals for controlling the electrical driver. The controller may, for example, comprise a storage device for storing data and a processing device for executing instructions comprised by the stored data. The stored data may, for example, comprise a sequence of providing an electrical drive current to the lasers or groups of lasers.

The laser arrangement or lighting device may be used in consumer devices (e.g. smartphones), vehicles as well as high power industrial applications in order to support
consumer and portable applications as gesture interface or 3D scanner in smart-phones, lap-top, tablet, ...
user interface or indoor navigation for robotics, sports, industry, lighting,...
high end for automotive mid-range detection (park assist, safe city driving), and
high power industrial applications.

According to the third aspect a time-of-flight camera is provided. The time-of-flight camera comprises the laser arrangement or light emitting device according to any embodiment described above, a light detector, an optical imaging structure and an evaluator. The optical imaging structure is arranged to image transformed laser light emitted by the laser arrangement and reflected by an object to the light detector. The evaluator is arranged to determine a distance to the object by means of the image of the transformed laser light detected by the light detector.

According to a fourth aspect a method of fabricating a laser arrangement according to any embodiment described above is provided. The method comprises the steps of:
providing at least one laser, preferably a laser array,
providing a diffusor,
arranging at least one surface of the diffusor such that the at least one surface is characterized along a first axis by a periodic continuously differentiable function with a first period, and
arranging the laser array to illuminate adjacent half periods with opposing radius of curvature of the surface along the first axis during operation of the laser arrangement.

The step of providing the laser array may comprise a step of providing a substrate and the subsequent step of providing at least two VCSELs, preferably a multitude of VCSELs on the substrate.

The steps need not necessarily be performed in the order given above. The method may comprise steps to manufacture any laser arrangement described above.

The diffusor may be provided by several methods, among them etching, soft-cushion imprint lithography followed by etching, UV-replication of a master structure on a wafer followed by an etch-transfer of the replicated structure in the semiconductor substrate and the like. Furthermore, wafer bonding of e.g. a glass wafer comprising a multitude of diffusors to, for example, a semiconductor wafer comprising a multitude of substrates may be used. Alternatively, a curable polymer may be provided and subsequently processed by means of processing light (e.g. UV or blue light). Details of such a process are described, for example, on page 2, line 2 to page 5, line 19 of WO 2017/055160 A1. Furthermore, Figures 2-10 and the corresponding description on page 9, line 20 to page 11, line 20 provides a special example of such a process. The disclosure of WO 2017/055160 A1 is incorporated by reference.

The diffusor may be covered by a planarization layer. The planarization layer is characterized by a lower refractive index than a material of the diffusor. The diffusor may be designed with respect to the refractive index of the planarization layer in order to provide the desired illumination pattern. The planarization layer may be used to smooth the surface irregularities caused by the diffusor. The planarization layer may comprise materials like silicone, epoxy, polyimide, SiN and the like. The difference between the refractive index of the diffusor and the refractive index of the planarization layer has to be sufficient to provide the illumination pattern for a multitude of applications. The planarization layer may protect the diffusor and may simplify further processing steps.

It shall be understood that the laser arrangement of claim 1-12, the light emitting device of claim 13 and the method of claim 15 have similar and/or identical embodiments, in particular, as defined in the dependent claims.

It shall be understood that a preferred embodiment of the invention can also be any combination of the dependent claims with the respective independent claim.

Further advantageous embodiments are defined below.

### BRIEF DESCRIPTION OF THE DRAWINGS

These and other aspects of the invention will be apparent from and elucidated with reference to the embodiments described hereinafter.

The invention will now be described, by way of example, based on embodiments with reference to the accompanying drawings.

In the drawings:
Fig. 1 shows a principal sketch of a surface of a prior art diffusor
Fig. 2 shows a principal sketch of a surface of a diffusor according to a first embodiment
Fig. 3 shows a principal sketch of a first laser arrangement
Fig. 4 shows a principal sketch of a second laser arrangement
Fig. 5 shows a principal sketch of a surface of a diffusor according to a second embodiment
Fig. 6 shows a principal sketch of the surface of a diffusor according to a third embodiment
Fig. 7 shows a principal sketch of a time-of-flight camera
Fig. 8 shows a principal sketch of a method of fabricating a laser arrangement
In the Figures, like numbers refer to like objects throughout. Objects in the Figures are not necessarily drawn to scale.

### DETAILED DESCRIPTION OF EMBODIMENTS:

Various embodiments of the invention will now be described by means of the Figures.

Fig. 1 shows a principal sketch of a surface of a prior art diffusor 135 comprising a multitude of discontinuities 136. The discontinuities cause scattering and diffraction losses outside the intended field of view as discussed above. Efficiency of a laser arrangement comprising such a prior art diffusor 135 may therefore be reduced.

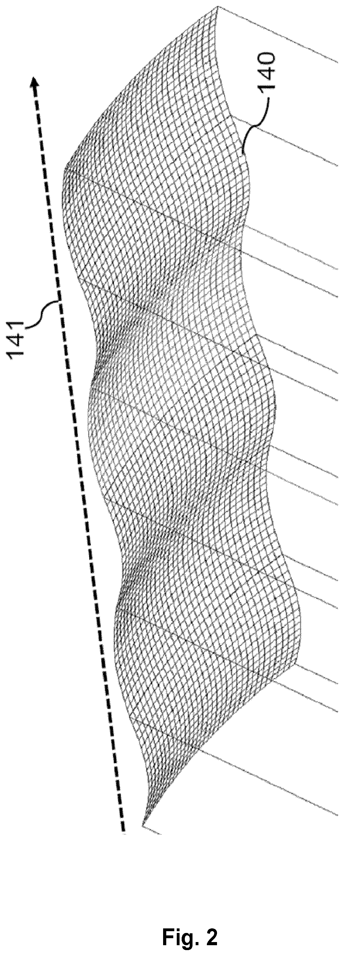

Fig. 2 shows a principal sketch of a surface of a diffusor 140 according to a first embodiment. The surface of the diffusor 140 is along a first axis 141 characterized by a smooth (continuously differentiable) function. Discontinuities as discussed with respect to Fig. 1 are thus avoided along the first axis 141. Optical losses may therefore be reduced. The smooth function may, for example, be a sinus function. Alternatively, a periodic, smooth function defining a strong conical profile may be preferred. Optical simulations have shown that smooth surface profiles of the diffusor 140 with alternating radius of curvature can provide exact the same beam profile as prior art diffusors discussed above but with reduced optical losses.

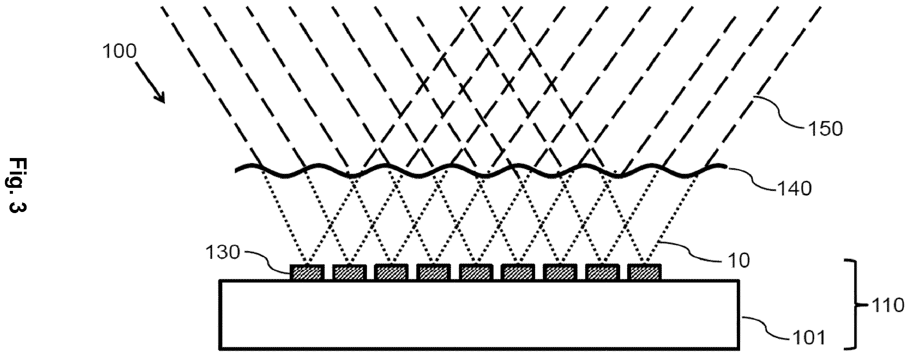

Fig. 3 shows a principal sketch of a first laser arrangement 100. The cross-section is taken across a line of VCSELs of a laser array 110 or VCSEL array comprised by the laser arrangement 100. Nine mesas of top emitting VCSELs provided on top of a semiconductor substrate 101 are shown. The laser arrangement 100 may in one embodiment comprise only one laser 130 (e.g. only one mesa). Each VCSEL emits laser light 10 with divergence angle of around 20° in air. A diffusor 140 is arranged above the VCSELs. The diffusor 140 comprises two parallel surfaces which are characterized by a periodic, continuously differentiable function along the first axis which is arranged in the plane of Fig. 3, parallel to the substrate 101 of the VCSEL array. The distance between the VCSEL array and the surface of the diffuser 140 facing the VCSELs is arranged such that each VCSEL illuminates in this embodiment a complete period (two adjacent half periods with opposing radius of curvature). Increasing the distance between the laser or VCSEL array and the diffuser 140 would have the effect that three, four, five or more half periods of the surfaces of the diffuser 140 are illuminated by the laser light of one VCSEL. The diffusor 140 transforms the laser light 10 received from the VCSEL array such that the transformed laser light 150 is spread in order to provide an illumination pattern with increased size in a reference plane in a field-of-view of the laser arrangement 100 in comparison to an untransformed illumination pattern which would be projected to the reference plane without the diffusor 140. The diffusor 140 may, for example, be arranged to change the beam profile of the laser light 10 in order to distribute the transformed laser light 150 across a large angle but at the same time restrict the illumination pattern to the predefined field-of-view in order to avoid optical losses.

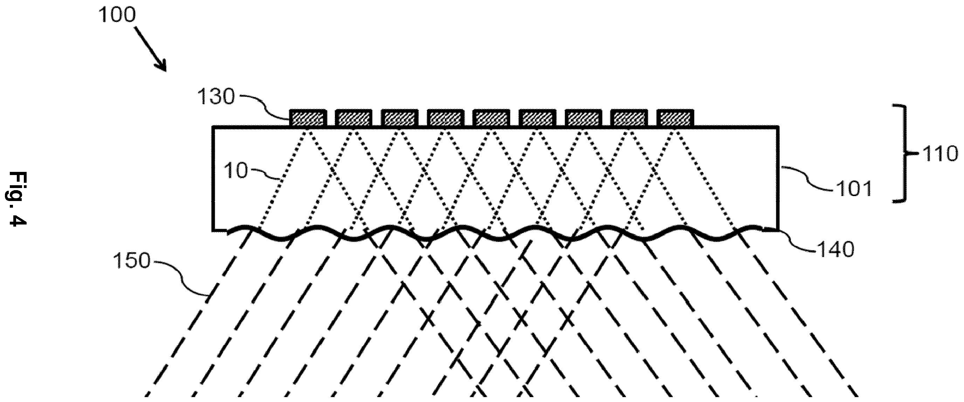

Fig. 4 shows a principal sketch of a second laser arrangement 100. The cross-section shows again an example with nine VCSELs. The VCSELs emit laser light 10 through the semiconductor substrate 101 (bottom emitter). The diffusor 140 is characterized by one surface of the semiconductor substrate 101 with a surface structure similar as discussed with respect to Fig. 2. The high refractive index of the GaAs semiconductor substrate 101 of n = 3.5 enables a rather low-profile of the surface structure of diffusor 140.

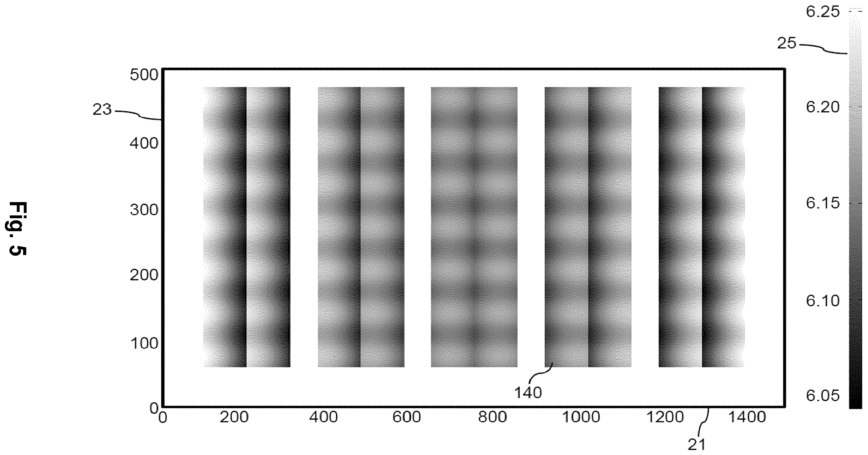

Fig. 5 shows a principal sketch of a surface of a diffusor system comprising diffusors 140 according to a second embodiment. The diffusor system comprises in this embodiment 10 diffusors 140 wherein the surface of the diffusor is characterized by a continuously differentiable function along a first axis (y-axis 23). Fig. 5 shows a height profile of the diffusor 140 along the y-axis 23 and the x-axis 21. The height 25 is indicated by means of the grayscale given at the right side of Fig. 5. Dark gray indicates a recess and bright gray indicates a raising in the height profile. Along the y-axis 23 one can see the smooth transition from one sub-lens to the next. Along the x-axis 21 the lenses are used for collimation and the laser light is not hitting the discontinuities between the diffusers 140, thus no optimization is needed for the x-axis 21. The distances between the lasers in a laser arrangement comprising such a diffusor system maybe different along the y-axis such that the cones of the laser light emitted by the lasers overlap along the first axis as discussed with respect to Fig. 3 and Fig. 4, wherein the distances between the lasers is bigger along the x-axis such that the discontinuities between the diffusers 14 or are not illuminated.

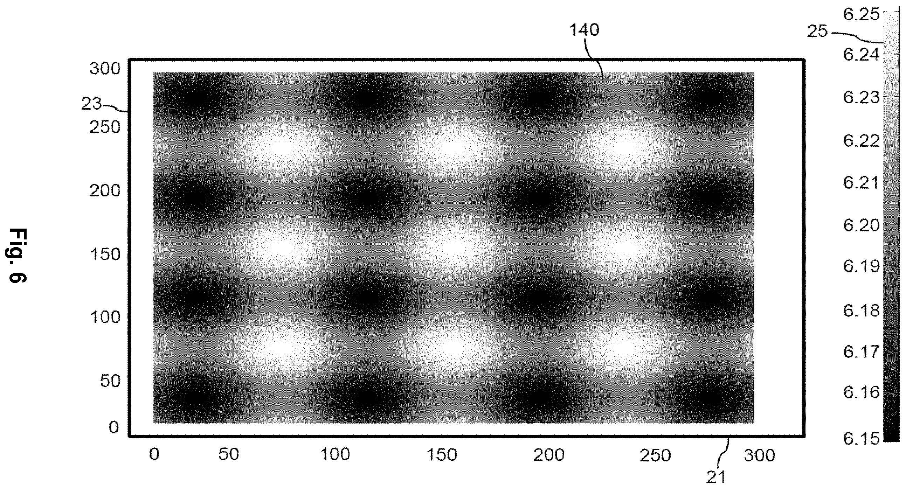

Fig. 6 shows a principal sketch of a surface of a diffusor 140 according to a third embodiment. A surface of the diffusor 140 is characterized by a two-dimensional continuously differentiable function which is periodic along a first axis (y-axis 23) and along a second axis (x-axis 21). Fig. 6 shows the height profile of the diffuser 140 in the same way as discussed with respect to Fig. 5. The lasers in the laser arrangement comprising the diffuser 140 according to the third embodiment may be arranged such that there is a strong overlap of the laser light emitted by the single lasers in a plane of the diffuser 140 along the x-axis 21 and the y-axis 23 as indicated in Fig. 3 and Fig. 4.

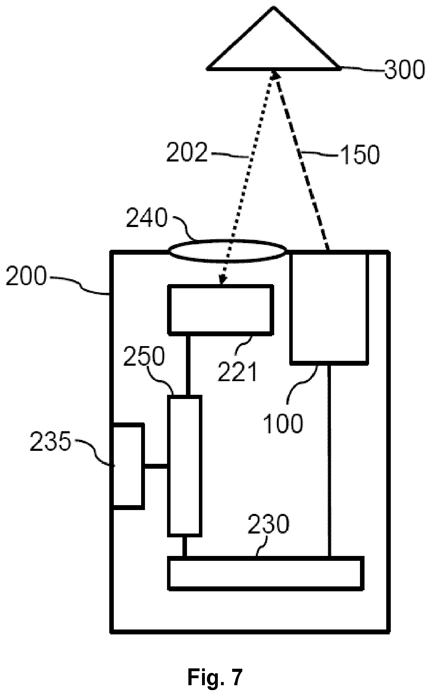

Fig. 7 shows a principal sketch of a time-of-flight camera 200. The time-of-flight camera 200 comprises a laser arrangement 100 in accordance with one of the embodiments discussed above. The time-of-flight camera 200 further comprises a detector 221 which is arranged to detect very short light pulses. Such short laser pulses may be caused by transformed laser light 150 emitted by a laser or VCSEL array comprised by the laser arrangement 100 hitting an object 300. A part of the transformed laser light 150 is reflected by the object 300 such that reflected laser light 202 is received by optical device 240 (e.g. lens or lens arrangement) which images or focuses the received laser light to detector 221. The reflected laser light 202 causes a corresponding electrical signal in the detector 221. An electrical driver 230 may be arranged to electrically drive the VCSEL array or optionally each VCSEL or sub-groups of VCSELs of the laser arrangement 100 separately. A controller 250 is connected to the electrical driver 230 in order to control, for example, start and stop time of the laser pulses emitted by VCSEL array. The controller 250 is further connected with the detector 221 in order to receive the electrical signal caused by the reflected laser light 202 detected by detector 221. The time-of-flight camera 200 further comprises an optional interface 235 to transfer start and stop time of the transformed laser light 150 emitted by the corresponding VCSEL or group of VCSELs as well as time of reception of the electrical signal caused by the reflected laser light 202. The transferred data can be used to calculate the time-of-flight of the laser light and therefore a distance between the time-of-flight camera 200 and the object 300. The time-of-flight camera 200 may alternatively comprise an evaluator (not shown) electrically connected with the controller 250 (or may comprise or be comprised by controller 250) in order to determine the distance to the object. Several distance measurements may be used to determine a velocity or even an acceleration of the object 300. The illumination pattern provided by means of the laser arrangement 100 may be adapted to the optical device 240. The intensity may, for example, increase at the rim of the illumination pattern in order to compensate for optical losses of the optical device 240.

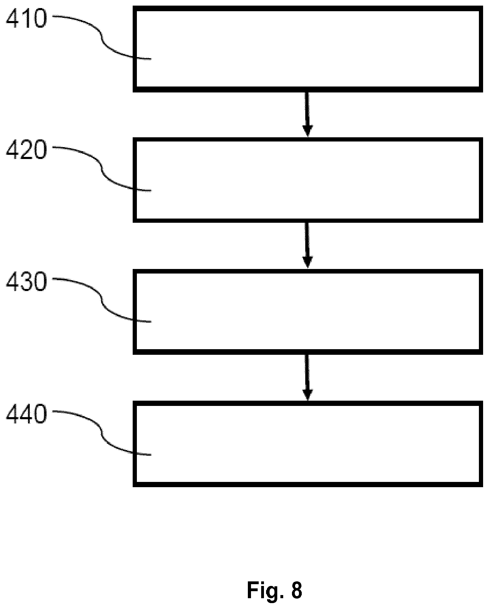

Fig. 8 shows a principal sketch of a method of fabricating a laser arrangement 100. A laser array 110 is provided in step 410. A diffusor 140 is provided in step 420. At least one surface of the diffusor 140 is arranged in step 430 such that the at least one surface is characterized along a first axis 141 by a periodic continuously differentiable function with a first period. The laser array is arranged in step 440 to illuminate adjacent half periods of the diffusor 140with opposing radius of curvature of the surface along the first axis 141 during operation of the laser arrangement 100.

While the invention has been illustrated and described in detail in the drawings and the foregoing description, such illustration and description are to be considered illustrative or exemplary and not restrictive.

From reading the present disclosure, other modifications will be apparent to persons skilled in the art. Such modifications may involve other features which are already known in the art and which may be used instead of or in addition to features already described herein.

Variations to the disclosed embodiments can be understood and effected by those skilled in the art, from a study of the drawings, the disclosure and the appended claims. In the claims, the word "comprising" does not exclude other elements or steps, and the indefinite article "a" or "an" does not exclude a plurality of elements or steps. The mere fact that certain measures are recited in mutually different dependent claims does not indicate that a combination of these measures cannot be used to advantage.

Any reference signs in the claims should not be construed as limiting the scope thereof.

### LIST OF REFERENCE NUMERALS:

- 10: laser light
- 21: x-axis
- 23: y-axis
- 25: height
- 100: laser arrangement
- 101: substrate
- 110: laser array
- 130: laser
- 135: prior art diffusor
- 136: discontinuity
- 140: diffusor
- 141: first axis
- 150: transformed laser light
- 200: time of flight camera
- 202: reflected laser light
- 221: light detector
- 230: electrical driver
- 235: interface
- 240: optical device
- 250: controller
- 300: object
- 410: step of providing laser array
- 420: step of providing diffusor
- 430: step of arranging diffusor
- 440: step of arranging laser array

## Claims

1. A laser arrangement (100) comprising at least one laser (130) and at least one optical structure for providing a defined illumination pattern in a defined field of view, wherein the optical structure comprises a diffusor (140), wherein at least one surface of the diffusor (140) is characterized along a first axis (141) by a periodic continuously differentiable function with a first period, wherein the at least one laser (130) is arranged to emit laser light (10) to adjacent half periods with opposing radius of curvature of the at least one surface along the first axis (141) during operation of the laser arrangement (100).

2. The laser arrangement (100) according to claim 1, wherein the laser arrangement comprises a laser array (110), wherein the laser array (110) comprises a Vertical Cavity Surface Emitting Laser array, wherein the Vertical Surface Emitting Laser array comprises at least two Vertical Cavity Surface Emitting Lasers arranged on a common substrate (101).

3. The laser arrangement (100) according to claim 1 or 2, wherein the absolute values of the opposing radius of curvature in the local extrema are the same for adjacent half periods along the first axis (141).

4. The laser arrangement (100) according to anyone of claims 2 or 3, wherein the at least one surface of the diffusor (140) is characterized along a second axis different than the first axis (141) by a periodic continuously differentiable function with a second period, wherein the at least one surface of the diffusor (140) is **characterized by** a two-dimensional continuously differentiable function, and wherein the Vertical Cavity Surface Emitting Laser array is arranged to emit the laser light (10) to adjacent half periods of the at least one surface with opposing radius of curvature along the first axis (141) and the second axis during operation of the laser arrangement (100).

5. The laser arrangement (100) according to claim 4, wherein the absolute values of the radius of curvature in the local extrema are different along the first axis (141) in comparison to the second axis.

6. The laser arrangement (100) according to anyone of claims 4 or 5, wherein the first period is different than the second period.

7. The laser arrangement (100) according to anyone of claims 2-6, wherein the Vertical Cavity Surface Emitting Laser array comprises Vertical Cavity Surface Emitting Lasers each arranged to emit the laser light to at least two adjacent half periods with opposing radius of curvature, preferably a multitude of adjacent half periods with opposing radius of curvature of the surface along at least the first axis (141) during operation of the laser arrangement (100).

8. The laser arrangement according to anyone of the preceding claims, wherein the first period is **characterized by** a size of at least 3 µm, preferably at least 4 µm and most preferably at least 5 µm.

9. The laser arrangement (100) according to any one of claims 2-8, wherein Vertical Cavity Surface Emitting Lasers are bottom emitting Vertical Cavity Surface Emitting Lasers which are arranged to emit the laser light (10) through the substrate (101), wherein the diffusor (140) is provided on a surface of the substrate (101) opposing the side of the substrate on which the Vertical Cavity Surface Emitting Lasers are provided.

10. The laser arrangement (100) according to claim 9, wherein the diffusor (140) is integrated in a semiconductor structure of the Vertical Cavity Surface Emitting Laser array.

11. The laser arrangement (100) according to anyone of claims 2-8, wherein the Vertical Cavity Surface Emitting Lasers are top emitting Vertical Cavity Surface Emitting Lasers which are arranged to emit the laser light (10) in a direction away from the substrate (101), wherein the diffusor (140) comprises a material provided on top of the side of the substrate (101) on which the Vertical Cavity Surface Emitting Lasers are provided, wherein the material is transparent in a wavelength range of the laser light (10).

12. The laser arrangement (100) according to anyone of claims 2-11, wherein at least a part of the Vertical Cavity Surface Emitting Lasers are arranged to be individually controlled to emit laser light (10).

13. A light emitting device comprising at least one laser arrangement (100) according to anyone of the preceding claims and an electrical driver (230) for providing an electrical drive current to the lasers (130).

14. A time-of-flight camera (200) comprising the light emitting device according to claim 13 or a laser arrangement (100) according to anyone of claims 1-12, a light detector (221) for detecting transformed laser light (150) reflected by an object (300) and an evaluator, wherein the evaluator is arranged to determine a distance to the object (300) by means of the transformed laser light (150) detected by the light detector (221).

15. A method of fabricating a laser arrangement (100), the method comprising the steps of:
providing at least one laser (130),
providing a diffusor (140),
arranging at least one surface of the diffusor (140) such that the at least one surface is characterized along a first axis (141) by a periodic continuously differentiable function with a first period, and
arranging the laser (130) to illuminate adjacent half periods with opposing radius of curvature of the at least one surface along the first axis (141) during operation of the laser arrangement (100).
